# EUROPÄISCHE PATENTSCHRIFT

(11) **EP 1 964 183 B1**
(45) Veröffentlichungstag und Bekanntmachung des Hinweises auf die Patenterteilung: **03.01.2018**
(21) Anmeldenummer: 06828550.1
(22) Anmeldetag: 21.11.2006
(51) Int. Cl.: H01L 33/14, H01L 33/42

(54) **LUMINESZENZDIODENCHIP MIT STROMAUFWEITUNGSSCHICHT**
LUMINESCENCE DIODE CHIP WITH CURRENT SPREADING LAYER
PUCE DE DIODE ELECTROLUMINESCENTE AVEC UNE COUCHE D'ELARGISSEMENT DE COURANT

(30) Priorität: 23.12.2005 DE 102005061797
(43) Veröffentlichungstag der Anmeldung: 03.09.2008
(73) Patentinhaber: OSRAM Opto Semiconductors GmbH, 93055 Regensburg (DE)
(72) Erfinder: HAHN, Berthold, 93155 Hemau (DE); WIRTH, Ralph, 93186 Pettendorf-Adlersberg (DE); ALBRECHT, Tony, 93077 Bad Abbach (DE); AHLSTEDT, Magnus, 93049 Regensburg (DE); ILLEK, Stefan, 93093 Donaustauf (DE); STREUBEL, Klaus, 93164 Laaber (DE)
(74) Vertreter: Epping - Hermann - Fischer
(86) Internationale Anmeldenummer: PCT/DE2006/002046
(87) Internationale Veröffentlichungsnummer: WO 2007/076743

(56) Entgegenhaltungen:
- US-A- 5 789 768
- US-B1- 6 420 732

## Beschreibung

Die vorliegende Erfindung betrifft einen Lumineszenzdiodenchip, der eine zur Erzeugung von elektromagnetischer Strahlung geeignete epitaktische Halbleiterschichtenfolge, einen elektrischen Anschlusskörper sowie eine mit dem Anschlusskörper elektrisch leitend verbundene strahlungsdurchlässige Stromaufweitungsschicht aufweist. Die Stromaufweitungsschicht enthält mindestens ein TCO (Transparent Conductive Oxide, oder Transparentes Leitfähiges Oxid), d.h. ein strahlungsdurchlässiges, elektrisch leitendes Material, das auf der Halbleiterschichtenfolge aufgebracht ist.

In der US 6,459,098 B1 ist eine lichtemittierende Diode angegeben, die auf einer Lichtauskoppelseite ein mehrschichtiges Fensterteil aufweist. Das Fensterteil umfasst eine erste Halbleiterschicht aus p-leitend dotiertem GaP, eine zweite Halbleiterschicht aus p-leitend dotiertem GaAs sowie eine amorphe elektrisch leitfähige schicht aus Indiumzinkoxid (ITO). Die ITO-Schicht und die zweite Halbleiterschicht sind mit einer Ausnehmung versehen, in die ein elektrischer Anschlusskörper aus Titan/Gold eingebracht ist, so dass er unmittelbar auf der ersten Halbleiterschicht aufliegt.

Zwischen dem Anschlusskörper und der ersten Halbleiterschicht ist ein Schottky-Dioden-Kontakt ausgebildet, so dass Strom im Wesentlichen nicht unmittelbar von dem Anschlusskörper in die erste Halbleiterschicht eingekoppelt wird, sondern zunächst seitlich in die zweite Halbleiterschicht und die ITO-Schicht injiziert wird. Dadurch wird in einem senkrecht unter dem

Anschlusskörper in dem Lumineszenzdiodenchip angeordneten Bereich eine verringerte Lichterzeugung erzielt. Die Richtungsangabe "senkrecht unter" dem Anschlusskörper bezieht sich dabei auf eine Haupterstreckungsebene von Halbleiterschichten der Halbleiterschichtenfolge.

Als Alternative zur Ausbildung eines Schottky-Diodenkontakts zwischen dem Anschlusskörper und der ersten Halbleiterschicht ist in der US 6,459,098 B1 angegeben, zwischen dem Anschlusskörper und der ersten Halbleiterschicht eine Isolatorschicht aus Silikonoxid auszubilden. Dadurch wird ebenfalls eine unmittelbare Strominjektion aus dem elektrischen Anschlusskörper in die erste Halbleiterschicht weitgehend verhindert.

In der US 5,717,226 ist ein Leuchtdiodenchip offenbart, der auf einer Lichtauskoppelseite ein ähnliches mehrschichtiges Fensterteil aufweist, wie der in der US 6,459,098 beschriebene Leuchtdiodenchip.

Aus der Druckschrift US 6,420,732 B1 ist eine Leuchtdiode mit einer verbesserten Stromblockschicht und mit einer Lichtauskoppelstruktur angegeben.

Die Druckschrift US 5,789,768 A betrifft eine Leuchtdiode, bei der sich ein transparentes leitfähiges Oxid in einer Kontaktschicht befindet.

Es ist eine Aufgabe der vorliegenden Erfindung, einen Lumineszenzdiodenchip der eingangsgenannten Art anzugeben, mit dem im Vergleich zu herkömmlichen Lumineszenzdiodenchips eine erhöhte Effizienz bei der Erzeugung und Auskopplung von elektromagnetischer Strahlung erzielt werden kann und der auf eine kostengünstige Weise herstellbar ist. Es soll zudem ein entsprechendes Verfahren zum Herstellen eines Lumineszenzdiodenchips angegeben werden.

Diese Aufgabe wird mit einem Lumineszenzdiodenchip gemäß Anspruch 1 gelöst.

Es wird ein Lumineszenzdiodenchip angegeben, der mindestens ein Strombarriere aufweist. Die Strombarriere ist geeignet, die Erzeugung der Strahlung in einem von dem elektrischen Anschlusskörper lateral bedeckten Bereich durch eine verringerte Stromdichte selektiv zu verhindern oder zu verringern. Unter "lateral" sind Richtungen zu verstehen, die parallel zu einer auf der Streckungsrichtung von Halbleiterschichten der epitaktischen Halbleiterschichtenfolge verlaufen.

Der Anschlusskörper überlappt mit dem Bereich, in dem die Erzeugung der Strahlung durch eine verringerte Stromdichte selektiv zu verhindern oder zu verringern ist, d.h. der Anschlusskörper überdeckt diesen Bereich teilweise oder vollständig. Insbesondere überlappt der Anschlusskörper lateral vollständig mit diesem Bereich. Der vom Anschlusskörper lateral bedeckte Bereich ist senkrecht unterhalb des Anschlusskörpers in der Halbleiterschichtenfolge angeordnet.

Durch die Strombarriere wird weniger Strom in den Bereich unter dem Anschlusskörper injiziert. Das bedeutet, dass in diesem Bereich keine oder zumindest weniger elektromagnetische Strahlung erzeugt wird und dass dadurch, verglichen mit herkömmlichen elektrischen Kontaktstrukturen ohne Strombarriere, weniger Strahlung von dem elektrischen Anschlusskörper absorbiert wird. Gleichzeitig sorgt die Stromaufweitungsschicht für eine besonders gute Stromaufweitung. Insbesondere bei sehr kleinen Lumineszenzdiodenchips, die in einer Haupterstreckungsebene der Halbleiterschichten typischerweise eine Fläche von ≤ 0,004 mm² haben, kann dadurch der Wirkungsgrad erheblich verbessert werden.

Die Stromaufweitungsschicht weist kein Halbleitermaterial auf.

Bevorzugt sind mehrere Strombarrieren enthalten, wodurch die Erzeugung von elektromagnetischer Strahlung in einem unerwünschten Bereich unterhalb des Anschlusskörpers weitergehend vermieden oder verringert werden kann. Mindestens eine Strombarriere ist enthalten, die Material der Stromaufweitungsschicht aufweist.

Dadurch kann die Strombarriere unabhängig von der Anordnung und der Ausdehnung des Anschlusskörpers ausgebildet sein. Zudem ermöglicht eine derartige Ausbildung der Strombarriere, den Lumineszenzdiodenchip in einem technisch einfachen und kostengünstigen Verfahren herzustellen.

Unter einer Grenzfläche zwischen der Halbleiterschichtenfolge und der Stromaufweitungsschicht ist keine Fläche im exakten mathematischen Sinne, sondern ein Grenzbereich zu verstehen, in dem Grenzflächeneffekte von Bedeutung sind. In diesem Sinne erstreckt sich die Grenzfläche auch zu einem geringen Teil in den Körper der Halbleiterschichtenfolge und der Stromaufweitungsschicht hinein, die Grenzfläche weist also im Sinne der vorliegenden Erfindung in der Regel eine Dicke auf.

Unter Halbleitermaterial der epitaktischen Halbleiterschichtenfolge und Material der Stromaufweitungsschicht ist insbesondere auch modifiziertes Material zu verstehen, das nicht zwingend alle üblichen Eigenschaften von Materialien aufweist, die in einer epitaktischen Halbleiterschichtenfolge oder in einer Stromaufweitungsschicht mit TCO üblicherweise enthalten sind. Beispielsweise kann Material der Stromaufweitungsschicht derart modifiziert sein, dass es im Unterschied zu dem unmodifizierten Material elektrisch isolierend ist. Material der epitaktischen Halbleiterschichtenfolge kann beispielsweise derart modifiziert sein, dass die regelmäßige Gitterstruktur teilweise oder vollständig zerstört ist.

Die Halbleiterschichten der Halbleiterschichtenfolge, die zwischen der Stromaufweitungsschicht und einer strahlungserzeugenden Zone angeordnet sind, weisen zweckmäßigerweise einen Schichtwiderstand von größer als 200 Qsq, bevorzugt von größer als 600 Qsq, besonders bevorzugt von größer als 2000 Qsq auf. Dadurch kann weitgehend vermieden werden, dass der elektrische Strom lateral in den Bereich fließt, in dem die Strahlungserzeugung unerwünscht ist.

Gemäß einer vorteilhaften Ausführungsform ist mindestens eine Strombarriere in dem Lumineszenzdiodenchip enthalten, die undotiertes oder derart schwach dotiertes Halbleitermaterial aufweist, das dessen elektrische Leitfähigkeit weniger als ein Zehntel der elektrischen Leitfähigkeit von einem an die Strombarriere angrenzenden Halbleitermaterial der Halbleiterschichtenfolge beträgt.

Zusätzlich oder alternativ ist mit Vorteil mindestens eine Strombarriere enthalten, die derart leitend dotiertes Halbleitermaterial aufweist, dass dieses Halbleitermaterial gemeinsam mit einem angrenzenden Halbleitermaterial bei Betrieb des Lumineszenzdiodenchips einen in Sperrrichtung betriebenen pn-übergang bildet.

Durch Strombarrieren mit Halbleitermaterial kann deren Herstellung vorteilhafterweise teilweise oder vollständig in den Epitaxieprozess zur Herstellung der Halbleiterschichtenfolge integriert sein.

In dem Lumineszenzdiodenchip ist gemäß einer weiteren Ausführungsform mindestens eine Strombarriere enthalten, die ein oxidiertes und/oder durch eingebrachte Ionen oder Atome derart modifiziertes Halbleitermaterial der epitaktischen Halbleiterschichtenfolge aufweist, dass dessen elektrische Leitfähigkeit weniger als ein Zehntel der elektrischen Leitfähigkeit von einem an die Strombarriere angrenzenden Halbleitermaterial beträgt.

Bevorzugt ist in der Halbleiterschichtenfolge mindestens eine Strombarriere mit Halbleitermaterial enthalten, wobei zwischen der Strombarriere und der Stromaufweitungsschicht eine strahlungserzeugende Zone angeordnet ist.

Zusätzlich oder alternativ ist besonders bevorzugt mindestens eine Strombarriere im Lumineszenzdiodenchip enthalten, die ein an die Stromaufweitungsschicht und/oder den elektrischen Anschlusskörper angrenzendes Halbleitermaterial aufweist.

Erfindungsgemäß ist in dem Lumineszenzdiodenchip mindestens eine Strombarriere enthalten, die einen Teil des TCO umfasst, wobei dieser Teil des TCO durch eingebrachte Ionen oder Atome derart modifiziert ist, dass seine elektrische Leitfähigkeit weniger als ein Zehntel der elektrischen Leitfähigkeit von einem übrigen TCO der Stromaufweitungsschicht beträgt.

Bevorzugt grenzt die Stromaufweitungsschicht an eine Halbleiterschicht der epitaktischen Halbleiterschichtenfolge an, wobei die die Grenzfläche einen ersten Teil und einen zweiten Teil aufweist. In dem ersten Teil ist ein elektrisch leitfähiger Kontakt zwischen der Stromaufweitungsschicht und der Halbleiterschicht ausgebildet. In dem zweiten Teil ist kein elektrisch leitfähiger Kontakt ausgebildet oder weist ein elektrisch leitfähiger Kontakt eine Leitfähigkeit von weniger als einem Zehntel der elektrischen Leitfähigkeit des Kontaktes in dem ersten Teil der Grenzfläche auf.

Eine zweckmäßige Ausführungsform sieht vor, dass der elektrische Anschlusskörper vollständig oder zu einem Großteil lateral mit der Stromaufweitungsschicht überlappt.

Bevorzugt ist gemäß einer weiteren Ausführungsform vorgesehen, dass die Stromaufweitungsschicht teilweise oder vollständig lateral mit mindestens einer Strombarriere überlappt. Besonders bevorzugt überlappt die Stromaufweitungsschicht mit allen Strombarrieren des Lumineszenzdiodenchips lateral teilweise oder vollständig.

Ein Teil der Stromaufweitungsschicht ist mit Vorteil auf einer von der Halbleiterschichtenfolge abgewandten Seite des Anschlusskörpers angeordnet. Dadurch kann eine besonders gute elektrisch leitfähige Verbindung zwischen dem Anschlusskörper und der Stromaufweitungsschicht ausgebildet werden.

Bei einer bevorzugten Weiterbildung des Lumineszenzdiodenchips ist mindestens eine Strombarriere enthalten, die lateral vollständig mit dem Anschlusskörper überlappt und den Anschlusskörper lateral überragt. Hierbei ist die Ausdehnung der Strombarriere parallel zu einer Haupterstreckungsebene von Schichten der Halbleiterschichtenfolge größer als die Ausdehnung des Anschlusskörpers entlang dieser Haupterstreckungsebene.

Mit Vorteil ist bei einer zweckmäßigen Ausführungsform des Lumineszenzdiodenchips zusätzlich eine Strombarriere enthalten, die durch eine Grenzfläche zwischen der Halbleiterschichtenfolge und dem elektrischen Anschlusskörper gebildet ist. Der Begriff "Grenzfläche" ist hier ebenso wie bei der Grenzfläche zwischen der Stromaufweitungsschicht und der Halbleiterschichtenfolge zu verstehen.

Bevorzugt ist bei dem Lumineszenzdiodenchip eine zwischen zwei Mantelschichten angeordnete strahlungserzeugende Zone enthalten, wobei die epitaktische Halbleiterschichtenfolge zwischen einer der Mantelschichten und der Stromaufweitungsschicht aus einem äußeren Teil besteht, der eine Dicke von kleiner als oder gleich 100 nm aufweist. Insbesondere weist die Halbleiterschichtenfolge eines derart beschaffenen Lumineszenzdiodenchips keine Stromaufweitungsschicht mit Halbleitermaterial auf. Durch den Verzicht auf eine solche Stromaufweitungsschicht kann die Halbleiterschichtenfolge dünner ausgebildet werden, was zusätzlich Aufwand und Kosten bei der Herstellung spart. Besonders bevorzugt weist der äußere Teil der Halbleiterschichtenfolge eine Dicke von kleiner als oder gleich 60 nm auf.

Es wird ein Verfahren zum Herstellen eines Lumineszenzdiodenchips angegeben, bei dem eine Halbleiterschichtenfolge epitaktisch aufgewachsen wird, eine Stromaufweitungsschicht mit einem TCO auf die Halbleiterschichtenfolge aufgebracht wird und ein elektrischer Anschlusskörper auf die Halbleiterschichtenfolge aufgebracht wird.

Bei dem Verfahren wird bevorzugt in der Halbleiterschichtenfolge, in der Stromaufweitungsschicht und/oder in einer Grenzfläche zwischen der Halbleiterschichtenfolge und der Stromaufweitungsschicht mindestens eine Strombarriere ausgebildet. Eine derartige Ausbildung einer Strombarriere kann mit Vorteil auf technisch einfache Weise und besonders kostengünstig erfolgen.

Bei dem Verfahren umfasst das Ausbilden der Strombarriere mit Vorteil, eine undotierte oder derart schwach dotierte Halbleiterschicht der Halbleiterschichtenfolge aufzubringen, dass deren elektrische Leitfähigkeit weniger als ein Zehntel der elektrischen Leitfähigkeit eines angrenzenden Halbleitermaterials beträgt. Zweckmäßigerweise wird die Außenschicht nachfolgend teilweise entfernt.

Zusätzlich oder alternativ umfasst das Ausbilden der Strombarriere, eine Halbleiterschicht der Halbleiterschichtenfolge derart leitend zu dotieren, dass sie gemeinsam mit angrenzendem Halbleitermaterial eine Sperrdiode in der herzustellenden Lumineszenzdiode bildet. Dadurch wird eine wirksame Strombarriere vorteilhafterweise mit technisch geringem Aufwand in den Epitaxieprozess zum Aufwachsen der halbleiterschichtenfolge integriert. Nachfolgend oder vorhergehend wird die Außenschicht zweckmäßigerweise teilweise entfernt.

Das Ausbilden der Strombarriere umfasst gemäß einer bevorzugten Ausführungsform des Verfahrens, nach dem epitaktischen Aufwachsen der Halbleiterschichtenfolge Ionen oder Atome in die Halbleiterschichtenfolge zu implantieren. Besonders bevorzugt werden die Ionen oder Atome durch eine strahlungserzeugende Zone der Halbleiterschichtenfolge hindurch implantiert. Es wurde überraschend festgestellt, dass dies möglich ist, ohne die strahlungserzeugende Zone zu zerstören.

Bei einer weiteren vorteilhaften Ausführungsform des Verfahrens umfasst das Ausbilden der Strombarriere, einen Teil einer Außenschicht der Halbleiterschichtenfolge und/oder einen Teil der Stromaufweitungsschicht zu oxidieren oder mittels Diffusion mit Fremdionen oder Fremdatomen zu versehen, so dass dieser Teil eine elektrische Leitfähigkeit von weniger als einem Zehntel der elektrischen Leitfähigkeit eines angrenzenden Halbleitermaterials oder eines anderen Teils der Stromaufweitungsschicht aufweist.

Bevorzugt wird bei dem Verfahren ein erster Teil der Stromaufweitungsschicht derart auf der Halbleiterschichtenfolge aufgebracht, dass sich ein elektrisch leitfähiger Kontakt zu der Halbleiterschichtenfolge ausbildet. Weiterhin wird ein zweiter Teil der Stromaufweitungsschicht derart auf der Halbleiterschichtenfolge aufgebracht, dass sich kein elektrisch leitfähiger Kontakt zu der Halbleiterschichtenfolge ausbildet oder dass sich ein elektrisch leitfähiger Kontakt mit einer Leitfähigkeit von weniger als einem Zehntel der elektrischen Leitfähigkeit des Kontaktes zwischen dem ersten Teil der Stromaufweitungsschicht und der Halbleiterschichtenfolge ausbildet.

Besonders bevorzugt umfasst das Ausbilden der Strombarriere zusätzlich oder alternativ, einen Teil einer Außenfläche der Halbleiterschichtenfolge aufzurauen und die Stromaufweitungsschicht auf diese Außenfläche aufzubringen. Das Aufrauen kann insbesondere auch während des Aufbringens der Stromaufweitungsschicht erfolgen, beispielsweise indem die Stromaufweitungsschicht auf die entsprechende Außenfläche mit ausreichend hoher Sputterenergie aufgesputtert wird.

In einer weiteren vorteilhaften Ausführungsform wird die Stromaufweitungsschicht nach dem elektrischen Anschlusskörper aufgebracht. Alternativ wird der elektrische Anschlusskörper zweckmäßigerweise vollständig auf der Stromaufweitungsschicht aufgebracht.

Weitere Vorteile, eine Ausführungsform, Abwandlungen und Weiterbildungen des Lumineszenzdiodenchips ergeben sich aus den Figuren 1 bis 13c. Es zeigen:
- Figuren 1 bis 8: schematische Schnittansichten von Abwandlungen von Lumineszenzdiodenchips,
- Figuren 9a bis 9e: schematische Schnittansichten von verschiedenen Verfahrensstadien zur Herstellung einer Abwandlung eines Lumineszenzdiodenchips,
- Figuren 10a bis 10f: schematische Schnittansichten von verschiedenen Verfahrensstadien zur Herstellung einer Abwandlung eines Lumineszenzdiodenchips,
- Figuren 11a und 11b: schematische Schnittansichten von verschiedenen Verfahrensstadien zur Herstellung einer Abwandlung eines Lumineszenzdiodenchips,
- Figuren 12a bis 12c: schematische Schnittansichten von verschiedenen Verfahrensstadien zur Herstellung einer Abwandlung eines Lumineszenzdiodenchips, und
- Figuren 13a bis 13c: schematische Schnittansichten von verschiedenen Verfahrensstadien zur Herstellung eines Ausführungsbeispiels eines Lumineszenzdiodenchips.

In dem Ausführungsbeispiel und in den Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Einige Details der Figuren können zum besseren Verständnis übertrieben groß dargestellt sein.

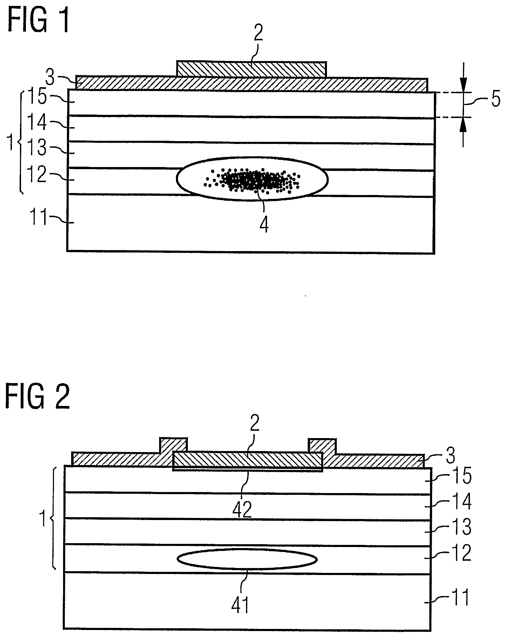

Die in den Figuren 1 bis 8 dargestellten Abwandlungen von Lumineszenzdiodenchips weisen jeweils ein Substrat 11 und eine auf dem Substrat angeordnete epitaktische Halbleiterschichtenfolge 1 auf. Das Substrat 11 kann ein Aufwachssubstrat sein, das heißt die Halbleiterschichtenfolge 1 ist in diesem Fall auf dem Substrat 11 epitaktisch aufgewachsen.

Alternativ ist das Substrat 11 ein bloßes Trägersubstrat, das heißt die Halbleiterschichtenfolge 1 ist nicht epitaktisch auf diesem Substrat aufgewachsen, sondern sie ist beispielsweise mittels Bonden oder Kleben auf dem Substrat 11 aufgebracht. Die Halbleiterschichtenfolge ist auch in diesem Fall z.B. durch epitaktisches Aufwachsen auf einem Aufwachssubstrat, das sich von dem Aufwachssubstrat 11 unterscheidet, hergestellt. Das Aufwachssubstrat kann teilweise oder vollständig entfernt sein oder auch vollständig im Lumineszenzdiodenchip enthalten sein, beispielsweise auf einer dem substrat 11 abgewandten Seite der Halbleiterschichtenfolge 1 (nicht dargestellt).

Die Lumineszenzdiodenchips weisen jeweils einen elektrischen Anschlusskörper 2 und eine elektrische Stromaufweitungsschicht 3 auf, die mit dem elektrischen Anschlusskörper 2 elektrisch leitend verbunden ist.

Der elektrische Anschlusskörper 2 ist für eine von dem Lumineszenzdiodenchip bei dessen Betrieb erzeugte elektromagnetische Strahlung undurchlässig. Er ist zum Beispiel als ein Bondpad ausgebildet und weist ein Metall oder mehrere verschiedene Metalle auf, beispielsweise in Form verschiedener Schichten und/oder Legierungen. Es können jegliche Metalle verwendet werden, die für die Verwendung in einem Bondpad allgemein üblich sind.

Die Stromaufweitungsschicht 3 ist für die vom Lumineszenzdiodenchip erzeugte Strahlung zumindest teildurchlässig. Er besteht beispielsweise zu einem Großteil aus einem TCO, das heißt aus einem strahlungsdurchlässigen, elektrisch leitenden Material wie Zinnoxid, Indiumoxid, Indiumzinnoxid oder Zinkoxid. Die Stromaufweitungsschicht 3 besteht beispielsweise aus Al_{0,02}Zn_{0,98}O und hat eine Dicke von zum Beispiel 500 nm.

Zusätzlich kann die Stromaufweitungsschicht 3 zum Beispiel ein Metall aufweisen, das beispielsweise in Form einer wenige Nanometer dicken Schicht zwischen dem TCO und der Halbleiterschichtenfolge angeordnet ist. Auf Grund ihrer geringen Dicke ist eine solche Metallschicht ebenfalls strahlungsdurchlässig, auch wenn das verwendete metallische Material grundsätzlich refeltkierend oder absorbierend für elektromagnetische Strahlung ist. Bevorzugt ist die Stromaufweitungsschicht jedoch frei von einer solchen strahlungsdurchlässigen Metallschicht zwischen dem TCO und der Halbleiterschichtenfolge 1.

Die Halbleiterschichtenfolge 1 weist beispielsweise zwischen dem Substrat 11 und der Stromaufweitungsschicht 3, in der Reihenfolge ausgehend vom Substrat 11, eine erste Mantelschicht 12, eine aktive Schicht 13 mit einer strahlungserzeugenden Zone, eine zweite Mantelschicht 14 und eine Kontaktschicht 15 auf. Die Halbleiterschichten können jeweils aus einer einzelnen Halbleiterschicht bestehen oder eine Schichtenfolge mit einer Mehrzahl von Halbleiterschichten aufweisen.

Die Halbleiterschichtenfolge basiert beispielsweise auf Phosphit-Verbindungshalbleitermaterialien. Dies sind Halbleitermaterialien, die Phosphor enthalten, beispielsweise aus dem System AlₙGaₘIn₁₋ₙ₋ₘP mit 0 ≤ n ≤ 1, 0 ≤ m ≤ 1 und n + m ≤ 1. Unter einem strahlungsemittierenden Lumineszenzdiodenchip auf Basis von Phosphit-Verbindungshalbleitermaterialien ist vorliegend insbesondere ein Lumineszenzdiodenchip zu verstehen, bei dem die Halbleiterschichtenfolge mindestens eine Einzelschicht enthält, die ein Material aus dem Phosphit-Verbindungshalbleitermaterialsystem aufweist. Bevorzugt enthält die Halbleiterschichtenfolge mehrere solcher Schichten.

Die erste und die zweite Mantelschicht 12, 14 weisen beispielsweise unterschiedlich leitend dotiertes AlInP auf. Die Kontaktschicht 15 enthält zum Beispiel Al_{0,5}Ga_{0,5}As. Die aktive Schicht kann beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Struktur) aufweisen. Solche Strukturen sind dem Fachmann bekannt und werden von daher an dieser Stelle nicht näher erläutert. Die aktive Schicht enthält zum Beispiel unterschiedliche AlGaInP-Materialien. Das Substrat 11 besteht beispielsweise aus GaAs. Die Kontaktschicht 15 und die zweite Mantelschicht 14 weisen jeweils eine hohe Querleitfähigkeit von beispielsweise etwa 700 Qsq auf.

Alternativ kann die Halbleiterschichtenfolge auch auf anderen Verbindungshalbleiter-Materialsystemen basieren. Ein grundsätzlich geeignetes alternatives Materialsystem sind Nitrid-Verbindungshalbleitermaterialien, wie zum Beispiel Materialien aus dem System InₓAl_{y}Ga_{1-x-y}N mit 0 ≤ x ≤ 1, 0 ≤ y ≤ 1 und x + y ≤ 1.

Bei der in Figur 1 dargestellten Abwandlung eines Lumineszenzdiodenchips ist die Stromaufweitungsschicht 3 in Form einer ebenen Schicht auf der Kontaktschicht 15 der Halbleiterschichtenfolge 1 ausgebildet. Der elektrische Anschlusskörper 2 ist auf der Stromaufweitungsschicht 3 aufgebracht. Er grenzt unmittelbar an die Stromaufweitungsschicht 3 und nicht an die epitaktische Halbleiterschichtenfolge 1 an. Mit anderen Worten ist der Anschlusskörper 2 von der Halbleiterschichtenfolge 1 beabstandet.

Die Halbleiterschichtenfolge 1 weist in Figur 1 einen Bereich auf, der als Strombarriere 4 fungiert. In diesem Bereich ist das Halbleitermaterial der Halbleiterschichtenfolge 1 beispielsweise durch eingebrachte Ionen derart modifiziert, dass dessen elektrische Leitfähigkeit zum Beispiel weniger als 1/20 der elektrischen Leitfähigkeit unmodifizierter Bereiche der ersten Mantelschicht 12 beträgt.

Die Strombarriere 4 ist im Wesentlichen in der ersten Mantelschicht 12 angeordnet. Darüber hinaus erstreckt sie sich auch teilweise in das angrenzende Substrat 11 und in die angrenzende aktive Schicht 13.

Das Halbleitermaterial der Strombarriere 4 ist beispielsweise mittels Protonen modifiziert. Neben dieser Strombarriere 4 kann der Lumineszenzdiodenchip noch weitere Strombarrieren aufweisen, auch wenn diese in Figur 1 nicht explizit dargestellt sind.

Die Strombarriere 4 schattet den Stromfluss durch die Halbleiterschichtenfolge 1 des Lumineszenzdiodenchips bei dessen Betrieb derart ab, dass die Erzeugung von elektromagnetischer Strahlung in einem Bereich der aktiven Schicht, der von dem Anschlusskörper 2 zumindest teilweise überdeckt ist, selektiv verringert wird. Elektromagnetische Strahlung, die in einem vom elektrischen Anschlusskörper 2 lateral überdeckten Bereich erzeugt wird, trifft, verglichen mit anderen Bereichen, mit einer besonders hohen Wahrscheinlichkeit auf den elektrischen Anschlusskörper 2 und wird von diesem absorbiert. Durch eine selektive Verringerung der in diesem Bereich erzeugten Strahlung wird somit auch die von dem elektrischen Anschlusskörper 2 absorbierte Strahlung signifikant verringert und die Gesamteffizienz des Lumineszenzdiodenchips gesteigert.

Zusätzlich wird der elektrische Strom durch die Stromaufweitungsschicht 3 effektiv über den gesamten oder nahezu gesamten lateralen Querschnitt des Lumineszenzdiodenchips aufgeweitet und insbesondere in Bereichen in die Halbleiterschichtenfolge 1 eingekoppelt, die nicht von dem elektrischen Anschlusskörper 2 überdeckt sind.

Durch die Verwendung der Stromaufweitungsschicht 3 mit einem TCO kann vorteilhafterweise auf eine Stromaufweitungsschicht aus Halbleitermaterial im Inneren der Halbleiterschichtenfolge 1 verzichtet werden. Stromaufweitungsschichten aus Halbleitermaterial sind in der Regel sehr hoch elektrisch leitend dotiert, was den Nachteil hat, dass sie meist einen höheren Absorptionskoeffizienten aufweisen, als ein weniger stark dotiertes Halbleitermaterial. Zudem weisen Stromaufweitungsschichten aus Halbleitermaterial in der Regel eine Dicke von einigen µm auf, um eine möglichst gute Stromaufweitung zu gewährleisten.

Der Verzicht auf eine derartige Stromaufweitungsschicht aus Halbleitermaterial reduziert somit die Absorption von elektromagnetischer Strahlung im Inneren der Halbleiterschichtenfolge und kann darüber hinaus auch die Herstellungskosten durch einen kostengünstigeren Epitaxieprozess zum Herstellen der Halbleiterschichtenfolge reduzieren.

Die epitaktischen Halbleiterschichtenfolgen 1 der in den Figuren 1 bis 8 dargstellten Abwandlungen von Lumineszenzdiodenchips enthalten keine Stromaufweitungsschicht aus Halbleitermaterial. Die Halbleiterschichtenfolge 1 der in Figur 1 dargestellten Abwandlung des Lumineszenzdiodenchips besteht zwischen der zweiten Mantelschicht 14 und der Stromaufweitungsschicht 3 aus einer Kontaktschicht 15, die beispielsweise eine Dicke 5 von 50 nm aufweist. Wie vorhergehend bereits erwähnt, kann die Kontaktschicht 15 insbesondere auch mehrere Halbleiterschichten aufweisen.

Die in Figur 2 dargestellte Abwandlung des Lumineszenzdiodenchips weist mindestens zwei Strombarrieren 41, 42 auf. Eine erste Strombarriere 41 ist in der Halbleiterschichtenfolge 1 ausgebildet. Sie kann im Wesentlichen so beschaffen sein, wie die vorhergehend anhand Figur 1 beschriebene Strombarriere 4. Die erste Strombarriere 41 ist beispielsweise vollständig innerhalb der ersten Mantelschicht 12 angeordnet.

Eine zweite Strombarriere 42 ist in einem Grenzbereich zwischen dem Anschlusskörper 2 und der Kontaktschicht 15 der Halbleiterschichtenfolge 1 ausgebildet. Der Anschlusskörper 2 grenzt unmittelbar an die Halbleiterschichtenfolge 1 an. Er ist derart auf die Kontaktschicht 15 aufgebracht, dass an der Grenzfläche ein Schottky-Kontakt ausgebildet ist, dessen Potentialbarriere sich bei Anlegen einer Spannung an dem Lumineszenzdiodenchip in Betriebsrichtung vergrößert. Dadurch wird ein Ladungstransport durch die Grenzfläche zwischen der Kontaktschicht 15 und dem Anschlusskörper 2 weitgehend reduziert.

Die Stromaufweitungsschicht 3 ist gemäß Figur 2 auf dem Anschlusskörper 2 aufgebracht. In denjenigen Bereichen der Außenfläche der Kontaktschicht 15, die frei von dem Anschlusskörper 2 sind, grenzt die Stromaufweitungsschicht 3 unmittelbar an die Halbleiterschichtenfolge 1 an.

Die Stromaufweitungsschicht 3 erstreckt sich auf eine Außenfläche des elektrischen Anschlusskörpers 2, die von der Halbleiterschichtenfolge 1 abgewandt ist. Dadurch ist ein lateraler Überlapp zwischen der Stromaufweitungsschicht 3 und dem Anschlusskörper 2 ausgebildet, der die elektrisch leitfähige Verbindung zwischen der Stromaufweitungsschicht zu dem Anschlusskörper erhöht, ohne dass sich der metallische Anschlusskörper 2 lateral über den Bereich der Strombarriere 42 hinaus erstreckt, wie wenn der elektrische Anschlusskörper z.B. auf der Stromaufweitungsschicht 3 aufgebracht ist und teilweise über die Stromaufweitungsschicht 3 ragt.

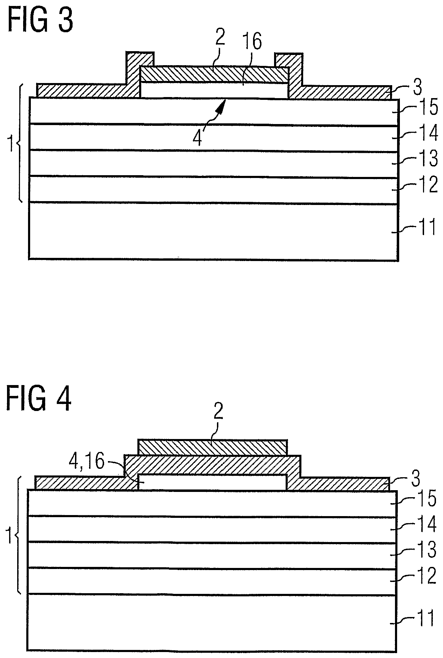

Wie anhand Figur 2 beschrieben erstreckt sich auch bei der in Figur 3 dargestellten Abwandlung des Lumineszenzdiodenchips die Stromaufweitungsschicht 3 auf eine Außenfläche des elektrischen Anschlusskörpers 2, die von der Halbleiterschichtenfolge 1 abgewandt ist.

Weiterhin weist der Lumineszenzdiodenchip eine Strombarriere 4 auf, die durch einen bei Betrieb des Lumineszenzdiodenchips sperrenden pn-Übergang gebildet ist. Hierzu enthält die Halbleiterschichtenfolge 1 beispielsweise eine Halbleiterschicht 16, die derart elektrisch leitend dotiert ist, dass sie gemeinsam mit der angrenzenden Kontaktschicht 15 den sperrenden pn-Übergang bildet. Zum Beispiel ist die Halbleiterschicht 16 n-leitend dotiert und die Kontaktschicht 15 p-leitend dotiert.

Die Halbleiterschicht 16 grenzt unmittelbar an den elektrischen Anschlusskörper 2 an. Zwischen dem Anschlusskörper 2 und der Halbleiterschicht 16 kann, zusätzlich zu der Strombarriere 4 in Form eines sperrenden pn-Überganges, ein Schottky-Kontakt ausgebildet sein. Die Seitenflanken der Halbleiterschicht 16 und des Anschlusskörpers 2 sind von der Stromaufweitungsschicht 3 bedeckt.

Bei der in Figur 4 dargestellten Abwandlung des Lumineszenzdiodenchips ist ebenfalls eine Strombarriere 4 mit einer Halbleiterschicht 16 der Halbleiterschichtenfolge 1 enthalten. Die Strombarriere 4 kann beispielsweise wie anhand der Figur 3 beschrieben ausgebildet sein. Alternativ ist die Halbleiterschicht 16 beispielsweise nicht oder nur sehr schwach elektrisch leitend dotiert, so dass sie keine elektrische Leitfähigkeit aufweist oder ihre elektrische Leitfähigkeit zum Beispiel weniger als ein Zwanzigstel der elektrischen Leitfähigkeit der Kontaktschicht 15 beträgt. In diesem Fall wird die Strombarriere 4 im maßgeblich durch die Halbleiterschicht 16 gebildet, wie in Figur 4 dargestellt ist.

Im Unterschied zu Figur 3 ist der Anschlusskörper 2 in Figur 4 von der Halbleiterschicht 16 beabstandet. Zwischen dem Anschlusskörper 2 und der Halbleiterschicht 16 verläuft die Stromaufweitungsschicht 3. Beispielsweise ist die Halbleiterschicht 16 vollständig von der Stromaufweitungsschicht 3 bedeckt. Der elektrische Anschlusskörper 2 ist zum Beispiel unmittelbar auf der Stromaufweitungsschicht 3 aufgebracht. Dadurch bildet sich eine großflächige Grenzfläche und kann sich ein besonders guter elektrisch leitfähiger Kontakt zwischen dem Anschlusskörper 2 und der Stromaufweitungsschicht 3 ausbilden.

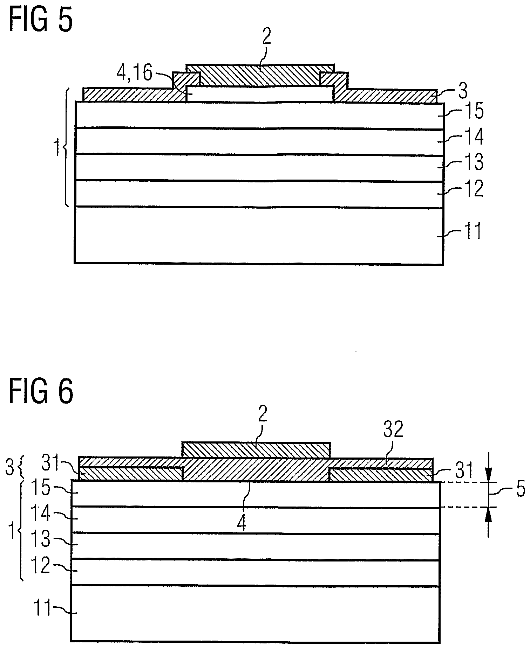

Bei der in Figur 5 dargestellten Abwandlung des Lumineszenzdiodenchips kann die Strombarriere 4 wie bei Figur 4 oder Figur 3 ausgebildet sein. Die Stromaufweitungsschicht 3 erstreckt sich teilweise auf eine von der Halbleiterschichtenfolge 1 abgewandte Seite der Halbleiterschicht 16, durch die die Strombarriere 4 teilweise oder im wesentlichen gebildet ist. Der elektrische Anschlusskörper 2 ist derart auf die Halbleiterschichtenfolge 1 aufgebracht, dass ein Teil unmittelbar an die Halbleiterschicht 16 angrenzt und ein weiterer Teil lateral mit dem auf der Halbleiterschicht 16 aufgebrachten Teil der Stromaufweitungsschicht 3 überlappt.

Zusätzlich zu der Strombarriere 4 kann auch in Figur 5 zwischen der Halbleiterschicht 16 und dem elektrischen Anschlusskörper 2 ein Schottky-Kontakt mit einer Potentialbarriere ausgebildet sein, die bei Betrieb des Lumineszenzdiodenchips sperrt.

Bei den in den Figuren 6 bis 8 dargestellten Abwandlungen von Lumineszenzdiodenchips ist der Anschlusskörper 2 jeweils von der Halbleiterschichtenfolge 1 beabstandet. Auf der Halbleiterschichtenfolge 1 ist jeweils eine Stromaufweitungsschicht 3 aufgebracht und der Anschlusskörper 2 ist auf der Stromaufweitungsschicht 3 angeordnet.

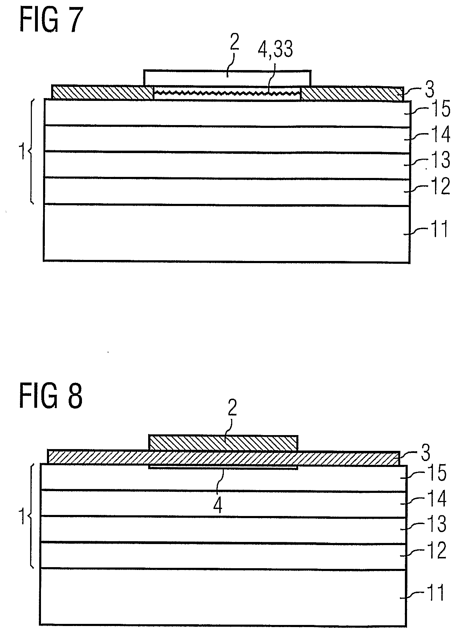

Bei den Abwandlungen der Lumineszenzdiodenchips, die in den Figuren 6 und 8 dargestellt sind, ist jeweils eine Strombarriere 4 durch eine Grenzfläche zwischen der Stromaufweitungsschicht 3 und der Halbleiterschichtenfolge 1 ausgebildet. Bei dem Ausführungsbeispiel gemäß 6 weist die Stromaufweitungsschicht 3 einen ersten Teil 31 und einen zweiten Teil 32 auf, die jeweils ein TCO enthalten. Als TCO ist in beiden Teilen 31, 32 der Stromaufweitungsschicht 3 beispielsweise das gleiche oder das selbe Material verwendet, z.B. ein Zinkoxid.

Zwischen dem ersten Teil 31 der Stromaufweitungsschicht 3 und der Kontaktschicht 15 der Halbleiterschichtenfolge 1 ist ein gut leitender elektrischer Kontakt ausgebildet, der bevorzugt ohmische Eigenschaften aufweist, d.h. er weist eine im Wesentlichen lineare Abhängigkeit des elektrischen Stroms von der angelegten Spannung auf. Der erste Teil 31 der Stromaufweitungsschicht 3 weist die Form einer ebenen Schicht auf, die in einem zentralen Bereich auf der Außenfläche der Halbleiterschichtenfolge 1 mit einer Aussparung versehen ist.

Der zweite Teil 32 der Stromaufweitungsschicht 3 ist derart auf dem ersten Teil 31 aufgebracht, dass er die Aussparung füllt und somit ebenfalls unmittelbar an die Halbleiterschichtenfolge 1 angrenzt. Allerdings ist zwischen dem zweiten Teil der Stromaufweitungsschicht 3 und der Kontaktschicht 15 der Halbleiterschichtenfolge 1 kein elektrisch leitfähiger Kontakt oder ein Kontakt mit geringer elektrischer Leitfähigkeit ausgebildet. Beispielsweise beträgt die elektrische Leitfähigkeit des Grenzbereiches zwischen des zweiten Teils 32 der Stromaufweitungsschicht 3 und der Halbleiterschichtenfolge 1 weniger als ein Zwanzigstel der elektrischen Leitfähigkeit des an der Grenzfläche zwischen dem ersten Teil 31 und der Halbleiterschichtenfolge 1 ausgebildeten Kontaktes.

Derart unterschiedliche elektrisch Leitfähigkeiten für die Grenzbereiche zwischen dem ersten Teil 31 der Stromaufweitungsschicht 3 und der Halbleiterschichtenfolge 1 einerseits und dem zweiten Teil 32 der Stromaufweitungsschicht 3 und der Halbleiterschichtenfolge 1 andererseits lassen sich beispielsweise durch ein Verfahren erzielen, bei dem die beiden Teile 31, 32 der Stromaufweitungsschicht 3 auf unterschiedliche Weise aufgebracht werden, wie nachfolgend im Zusammenhang mit den beispielhaften Verfahren näher erläutert ist.

Die in Figur 8 dargestellte Abwandlung des Lumineszenzdiodenchips unterscheidet sich von dem vorhergehend anhand Figur 6 beschriebenen dadurch, dass die Stromaufweitungsschicht 3 einteilig ausgebildet und insbesondere in einem einzigen Verfahrensschritt aufgebracht sein kann. Dennoch ist in äußeren Bereichen des Lumineszenzdiodenchips zwischen der Stromaufweitungsschicht 3 und der Halbleiterschichtenfolge 1 ein gut leitender elektrischer Kontakt ausgebildet, während dies in einem zentralen Bereich des Lumineszenzdiodenchips nicht der Fall ist.

In dem zentralen Bereich ist zwischen der Stromaufweitungsschicht 3 und der Halbleiterschichtenfolge 1 eine Strombarriere 4 ausgebildet. Beispielsweise bildet die Stromaufweitungsschicht 3 in diesem Bereich mit der Kontaktschicht 15 einen Schottky-Kontakt, der bei Anlegen einer Betriebsspannung an den Lumineszenzdiodenchip sperrend ist. Der Grenzbereich zwischen der Stromaufweitungsschicht 3 und der Halbleiterschichtenfolge 1 weist in dem zentralen Bereich der Strombarriere 4 zum Beispiel eine elektrische Leitfähigkeit auf, die weniger als ein Fünfundzwanzigstel der elektrischen Leitfähigkeit zwischen der Stromaufweitungsschicht 3 und der Halbleiterschichtenfolgen in den übrigen Bereichen beträgt.

Eine derartige selektive elektrische Anbindung der Stromaufweitungsschicht 3 an die Halbleiterschichtenfolge 1 kann beispielsweise erzielt werden, indem die Oberfläche der Halbleiterschichtenfolge 1 in dem für die Strombarriere 4 vorgesehenen Bereich vor dem Aufbringen der Stromaufweitungsschicht 3 vorbehandelt wird. Auch dies ist nachfolgend im Zusammenhang mit den Ausführungsbeispielen des Verfahrens näher erläutert.

Die in Figur 7 dargestellte Abwandlung des Lumineszenzdiodenchips weist eine Strombarriere 4 auf, die aus Material der Stromaufweitungsschicht 3 besteht. Hierzu ist ein Teilbereich 33 der Stromaufweitungsschicht modifiziert, so dass die elektrische Leitfähigkeit dieses Teiles 33 signifikant herabgesetzt ist, beispielsweise um 95%.

Der elektrische Anschlusskörper 2 ist bei diesem Ausführungsbeispiel auf dem modifizierten Teil 33, d.h. auf der Strombarriere 4 aufgebracht. Damit dennoch ein gut leitender elektrischer Kontakt zu dem übrigen Teil der Stromaufweitungsschicht 3 ausgebildet ist, überragt der Anschlusskörper 2 die Strombarriere 4 lateral, so dass ein lateraler Überlapp mit dem gut leitfähigen Teil der Stromaufweitungsschicht 3 besteht. Im Bereich des Überlappes ist der Anschlusskörper 2 elektrisch leitend mit dem gut leitfähigen Teil der Stromaufweitungsschicht 3 verbunden.

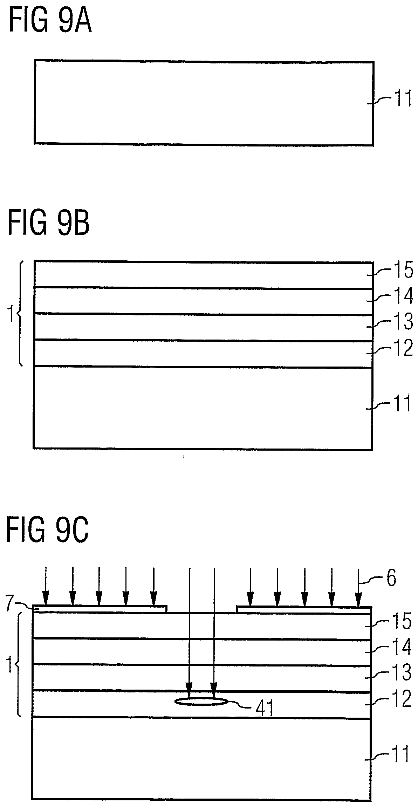

In den Figuren 9A bis 9E sind verschiedene Verfahrensstadien eines Verfahrens dargestellt, bei dem zunächst ein Aufwachssubstrat 11 bereitgestellt wird, siehe Figur 9A. Nachfolgend wird auf das Substrat 11 eine Halbleiterschichtenfolge 1 epitaktisch aufgewachsen, siehe Figur 9B. Alternativ ist es auch möglich, eine fertige Halbleiterschichtenfolge 1 mit oder ohne Substrat 11 bereitzustellen.

In einem weiteren Verfahrensschicht werden Ionen in die Halbleiterschichtenfolge 1 implantiert. Damit dies nicht über den gesamten lateralen Querschnitt des Lumineszenzdiodenchips erfolgt, wird die Halbleiterschichtenfolge 1 vorhergehend mit einer Maske 7 versehen. Diese ist für die Ionenstrahlen 6 undurchlässig und weist eine Aussparung über dem Bereich auf, der für eine erste Strombarriere 41 vorgesehen ist.

Als Ionen eignen sich alle Arten von Ionen, die geeignet sind, eine elektrische Leitfähigkeit in einem Teilbereich der Halbleiterschichtenfolge 1 zu zerstören oder zumindest signifikant herabzusetzen. Beispielsweise werden Protonen verwendet. Diese werden in dem beschriebenen Ausführungsbeispiel mit einer derart hohen Energie auf die Halbleiterschichtenfolge 1 geschossen, dass sie die aktive Schicht 13, in der eine strahlungserzeugende Zone enthalten ist, durchdringen und in der zwischen der aktiven Schicht 13 und dem Substrat 11 angeordneten ersten Mantelschicht 12 implantiert werden. Dadurch wird eine erste Strombarriere 41 in der Halbleiterschichtenfolge 1 ausgebildet, siehe Figur 9C.

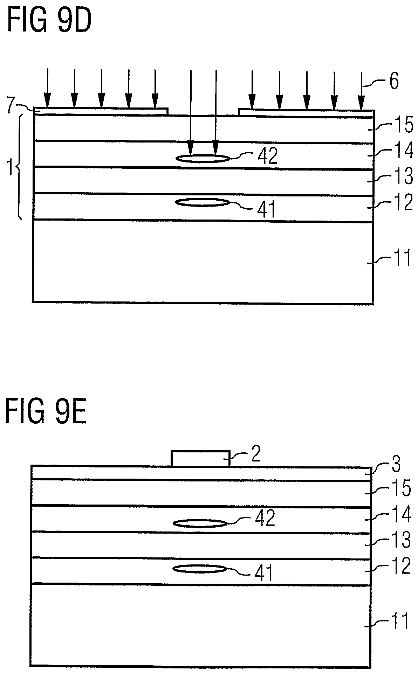

In Figur 9D ist schematisch dargestellt, wie in einem zweiten Implantierungsschritt eine zweite Strombarriere 42 in der Halbleiterschichtenfolge 1 ausgebildet wird. Hierzu kann zum Beispiel dieselbe Maske verwendet werden. Es werden zum Beispiel zum Beispiel negativ geladene Ionen verwendet.

Die zweite Strombarriere 42 ist in einer zweiten Mantelschicht 14 angeordnet, die auf einer der ersten Mantelschicht 12 gegenüber liegenden Seite der aktiven Schicht 13 in der Halbleiterschichtenfolge 1 enthalten ist. Durch die zwei Strombarrieren 41, 42 wird einen zentraler Bereich der aktiven Schicht 13 effektiv vor elektrischen Strom abgeschattet, so dass die Erzeugung elektromagnetischer Strahlung in diesem Bereich verglichen mit einem Lumineszenzdiodenchip ohne Strombarrieren bei Betrieb signifikant reduziert ist.

Nach dem Ausbilden der beiden Strombarrieren wird das Maskenmaterial 7 beispielsweise mittels Ätzen entfernt. Nachfolgend wird eine Stromaufweitungsschicht 3 beispielsweise mittels Sputtern auf der Halbleiterschichtenfolge 1 aufgebracht. Auf der Stromaufweitungsschicht 3 wird ein Anschlusskörper 2 beispielsweise mittels Aufdampfen von metallischem Material ausgebildet und gegebenenfalls strukturiert, siehe Figur 9E.

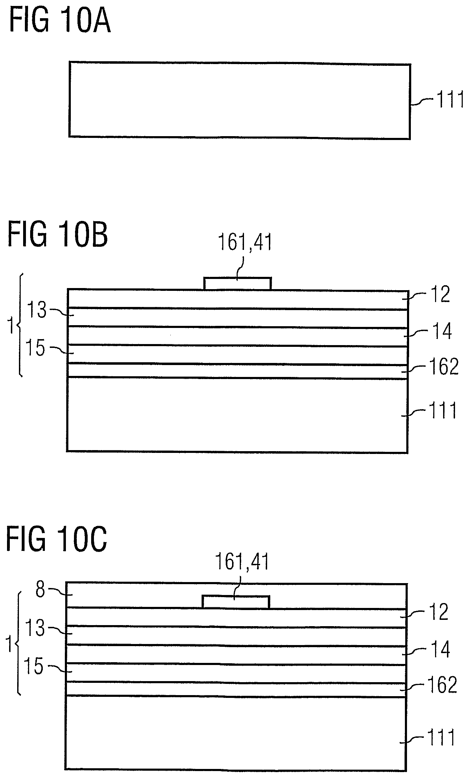

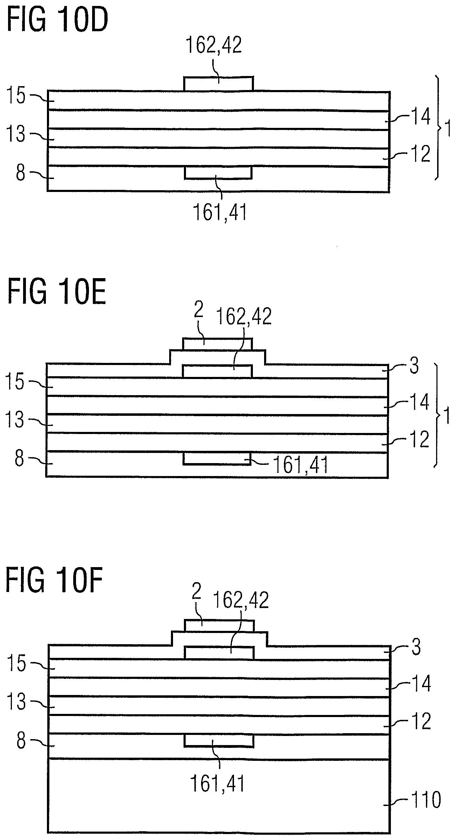

Bei dem anhand der Figuren 10A bis 10F grafisch veranschaulichten Verfahren wird beispielsweise ein Aufwachssubstrat 111 bereitgestellt, auf das nachfolgend eine epitaktische Halbleiterschichtenfolge 1 aufgebracht wird, siehe Figuren 10A und 10B. Die Halbleiterschichtenfolge 1 weist, ausgehend von dem Aufwachssubstrat 111, der Reihenfolge nach eine zweite Halbleiterschicht 162, die für eine Strombarriere vorgesehen ist, eine Kontaktschicht 15, eine zweite Mantelschicht 14, eine aktive Schicht 13, eine erste Mantelschicht 12 sowie eine erste Halbleiterschicht 161 auf, die für eine Strombarriere vorgesehen ist.

Die erste und die zweite für eine Strombarriere vorgesehenen Halbleiterschichten 161, 162 bestehen beispielsweise aus einem undotierten Halbleitermaterial, das nicht oder nur sehr schlecht elektrisch leitfähig ist. Alternativ sind diese Halbleiterschichten derart leitend dotiert, dass sie mit einer jeweils angrenzenden Halbleiterschicht einen sperrenden pn-Übergang in dem herzustellenden Lumineszenzdiodenchip bilden.

Die erste für eine Strombarriere vorgesehene Halbleiterschicht 161 wird beispielsweise als letzte Schicht der Halbleiterschichtenfolge 1 epitaktisch aufgewachsen. Nachfolgend wird diese Schicht beispielsweise mittels Lithographie teilweise derart entfernt, dass ein Teil der Schicht in der Mitte der Halbleiterschichtenfolge 1 bestehen bleibt und somit eine erste Strombarriere 41 bildet, siehe Figur 10B.

In einem weiteren Verfahrensschritt wird ein rückseitiger elektrischer Anschlusskörper 8 auf der ersten Strombarriere 41 und dem freigelegten Teil der ersten Mantelschicht 12 aufgebracht. Dies ist in Figur 10C dargestellt. Der rückseitige Anschlusskörper weist beispielsweise ein Metall auf, das sowohl geeignet ist, ein elektrisch leitfähigen Kontakt zu der ersten Mantelschicht 12 auszubilden, als auch eine elektromagnetische Strahlung, die mit dem herzustellenden Lumineszenzdiodenchip erzeugt werden kann, zu reflektieren.

In einem weiteren Verfahrensschritt wird das Aufwachssubstrat 111 von der Halbleiterschichtenfolge 1 abgelöst. Zudem wird die zweite für eine Strombarriere vorgesehene Halbleiterschicht 162 in analoger Weise wie die erste Halbleiterschicht 161 mittels eines lithographischen Verfahrens strukturiert, d.h. teilweise entfernt, so dass ein zentraler Bereich bestehen bleibt. Dieser verbleibende Teil der Halbleiterschicht 162 bildet eine zweite Strombarriere 42.

Alternativ ist es auch möglich, bei dem Verfahren keine zweite für eine Strombarriere vorgesehene Halbleiterschicht 162 epitaktisch auf einem Substrat aufzuwachsen, sondern zum Beispiel ein elektrisch nicht oder schlecht leitendes Substrat zu verwenden und einen Teil dieses Substrates für die zweite Strombarriere 42 zu verwenden. Dies erfolgt beispielsweise durch ein Abdünnen des Substrates. Der verbleibende Rest des Substrates kann dann beispielsweise analog wie die Halbleiterschichten 161, 162 strukturiert werden.

Nachfolgend wird eine Stromaufweitungsschicht 3 auf der Kontaktschicht 15 und der zweiten Strombarriere 42 aufgebracht. Auf der Stromaufweitungsschicht 3 wird über der zweiten Strombarriere 42 ein elektrischer Anschlusskörper 2 ausgebildet, siehe Figur 10E.

In Figur 10E ist bereits ein fertiger Lumineszenzdiodenchip dargestellt, der eine nicht erfindungsgemäße Abwandlung ist. Dieser weist auf einer Seite der Halbleiterschichtenfolge 1, die der Stromaufweitungsschicht 3 abgewandt ist, kein Substrat auf. Der so ausgebildete Lumineszenzdiodenchip kann beispielsweise in einen Gehäuse montiert werden.

Optional kann die in Figur 10E dargestellt Struktur auch auf ein Trägersubstrat 110 aufgebracht werden, wie in Figur 10F dargestellt ist. Das Aufbringen erfolgt zum Beispiel mittels Bonden, beispielsweise mittels eines geeigneten Lotes oder mittels Kleben. Zum Kleben kann insbesondere auch ein elektrisch leitfähiger Klebstoff verwendet werden, was insbesondere dann zweckmäßig ist, wenn das Trägersubstrat 110 auch elektrisch leitfähig ist.

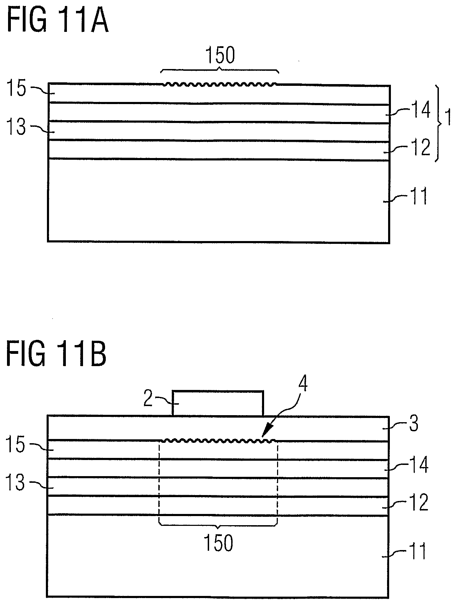

Bei dem Verfahren, das anhand der Figuren 11A und 11B veranschaulicht ist, wird eine Halbleiterschichtenfolge 1 bereitgestellt. Eine Außenfläche der Halbleiterschichtenfolge 1, beispielsweise eine Kontaktschicht 15, wird nachfolgend in einem Teilbereich 150, der für das Ausbilden einer Strombarriere vorgesehen ist, vorbehandelt. Bei dem Vorbehandeln wird der Teilbereich 150 der Außenfläche der Halbleiterschichtenfolge 1 beispielsweise aufgeraut. Das Aufrauen erfolgt z.B. durch Beschießen mit Partikeln, wofür zum Beispiel ein Argonplasma verwendet werden kann.

Der so vorbehandelte Teilbereich 150 weist eine feine Rauhigkeit mit geringer Strukturgröße und Strukturtiefe auf. Eine Größe von Strukturelementen und die Strukturtiefe sind beispielsweise kleiner als 200 nm oder 100 nm. Nachfolgend wird z.B. ein TCO wie Zinkoxid auf die Kontaktschicht 15 aufgebracht, was mittels Sputtern erfolgen kann. In dem vorbehandelten Teilbereich 150 bildet sich entweder kein elektrisch leitfähiger Kontakt oder ein sehr viel schlechterer elektrisch leitfähiger Kontakt zwischen der Stromaufweitungsschicht 3 und der Kontaktschicht 15 aus als in den übrigen Bereichen. Dadurch wird in dem Teilbereich 150 auf technisch einfache Weise eine Strombarriere 4 erzeugt. Auf der Stromaufweitungsschicht 3 wird beispielsweise oberhalb der Strombarriere 4 ein Anschlusskörper 2 ausgebildet, siehe Figur 11B.

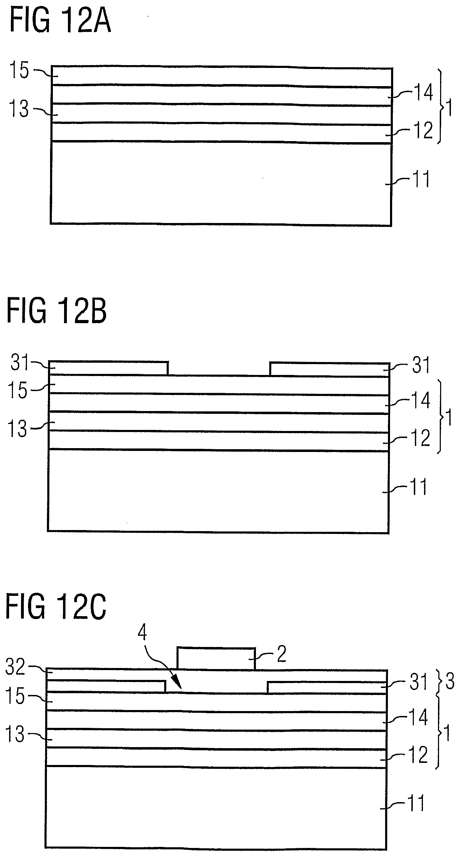

In den Figuren 12A bis 12C ist ein Verfahren veranschaulicht, bei dem eine mehrteilige Stromaufweitungsschicht 3 hergestellt wird und/oder bei dem die Stromaufweitungsschicht 3 in mehreren separaten Verfahrensschritten aufgebracht wird.

Bei dem Verfahren wird zunächst eine Halbleiterschichtenfolge 1 bereitgestellt, siehe Figur 12A. Nachfolgend wird ein erster Teil 31 einer Stromaufweitungsschicht 3 in herkömmlicher Weise derart auf der Halbleiterschichtenfolge 1 aufgebracht, dass sich ein gut leitender elektrischer Kontakt zu der Halbleiterschichtenfolge 1 ausbildet. Der erste Teil 31 der Stromaufweitungsschicht 3 wird in Form einer ebenen Schicht aufgebracht, die nachfolgend in einem Bereich, der für eine Strombarriere vorgesehen ist, entfernt wird, siehe Figur 12B. Das Aufbringen des ersten Teils 31 der Stromaufweitungsschicht 3 erfolgt beispielsweise durch Aufsputtern eines TCOs wie Zinkoxid. Beim Sputterprozess weisen die aufzusputternden Teilchen eine kinetische Energie von beispielsweise wenigen Elektronenvolt auf, zum Beispiel kleiner als 5 eV.

Nachfolgend wird ein zweiter Teil 32 der Stromaufweitungsschicht 3 auf dem ersten Teil 31 aufgebracht. Hierfür wird ebenfalls Sputtern verwendet, wobei dieser Sputterprozess mit einer sehr viel höheren Sputterenergie erfolgt, als der Sputterprozess zum Aufbringen des ersten Teils 31 der Stromaufweitungsschicht 3. Mit anderen Worten weisen die aufzusputternden Teilchen bei dem zweiten Sputterprozess eine deutlich höhere kinetische Energie auf. Diese ist ungefähr eine Größenordnung höher als die kinetische Energie beim ersten Sputterprozess. Beispielsweise ist die kinetische Energie beim zweiten Sputterprozess um einen Faktor 10 bis 20 größer.

Mit diesem Verfahren bildet sich zwischen dem zweiten Teil 32 der Stromaufweitungsschicht 3 und der Halbleiterschichtenfolge 1 kein elektrisch leitfähiger Kontakt oder ein sehr viel schlechterer elektrisch leitfähiger Kontakt aus, als zwischen dem ersten Teil 31 und der Halbleiterschichtenfolge 1. Eine Grenzfläche zwischen dem zweiten Teil 32 der Stromaufweitungsschicht 3 und der Kontaktschicht 15 der Halbleiterschichtenfolge 1 bildet bei diesem Lumineszenzdiodenchip eine Strombarriere 4. Auf der Stromaufweitungsschicht 3 wird nachfolgend über der Strombarriere 4 ein Anschlusskörper 2 ausgebildet, siehe Figur 12C.

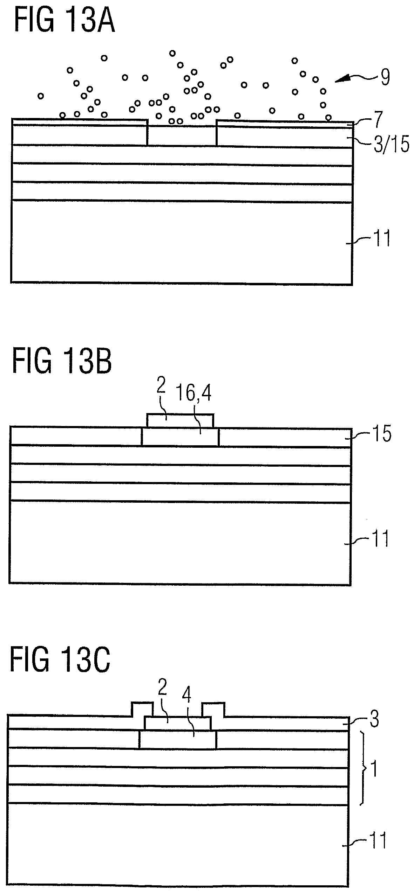

Bei dem in den Figuren 13A bis 13C veranschaulichten Ausführungsbeispiel wird eine Strombarriere 4 ausgebildet, indem ein Teilbereich einer Stromaufweitungsschicht 3 durch Eindiffundieren von Atomen oder Ionen 9 modifiziert wird, siehe Figur 13A.

Hierzu wird auf der zu modifizierenden Schicht eine Maske 7 aus einem geeigneten Maskenmaterial ausgebildet, das für die Diffusionspartikel 9 undurchlässig ist. Zum Eindiffundieren werden Partikel gewählt, die geeignet sind, eine elektrische Leitfähigkeit der Stromaufweitungsschicht 3 signifikant zu reduzieren. Beispielsweise wird Lithium oder Kupfer eindiffundiert.

In einer nicht erfindungsgemäßen Abwandlung ist es auch möglich, den zu modifizierenden Teil der Schicht zu oxidieren. Die von der Maske 7 ungeschützten Stellen werden hierfür z.B. mit einem O2-Plasma oder in einem Oxidationsofen bei einer ausreichend hohen Temperatur behandelt. Dadurch kann ebenfalls eine selektive Verringerung oder Zerstörung der Leitfähigkeit des Materials erzielt werden, so dass eine Strombarriere 4 ausgebildet werden kann, siehe Figur 13B. Unmittelbar auf der Strombarriere 4 wird ein elektrischer Anschlusskörper 2 ausgebildet, auf dem nachfolgend eine Stromaufweitungsschicht 3 aufgebracht wird, siehe Figur 13C. Ein Teil des Anschlusskörpers 2 wird in einem Verfahrensschritt durch selektives Entfernen der Stromaufweitungsschicht 3 freigelegt, so dass der Lumineszenzdiodenchip über den Anschlusskörper 2 elektrisch leitend von außen kontaktiert werden kann.

## Patentansprüche

1. Lumineszenzdiodenchip, der eine zur Erzeugung von elektromagnetischer Strahlung geeignete epitaktische Halbleiterschichtenfolge (1), einen elektrischen Anschlusskörper (2), eine mit dem Anschlusskörper elektrisch leitend verbundene strahlungsdurchlässige Stromaufweitungsschicht (3) mit einem TCO (transparenten leitfähigen Oxid), und mindestens
eine Strombarriere (4) aufweist, die geeignet ist, die Erzeugung der Strahlung in einem vom Anschlusskörper (2) lateral bedeckten Bereich durch eine verringerte Stromdichte selektiv zu verhindern oder zu verringern,
**dadurch gekennzeichnet, dass**
die Strombarriere oder zumindest eine der Strombarrieren aus Material der Stromaufweitungsschicht gebildet ist, sodass die Strombarriere (4) einen Teil des TCO der Stromaufweitungsschicht (3) umfasst, wobei dieser Teil des TCO durch eingebrachte Ionen oder Atome derart modifiziert ist, dass seine elektrische Leitfähigkeit weniger als ein Zehntel der elektrischen Leitfähigkeit von einem übrigen TCO der Stromaufweitungsschicht (3) beträgt.

2. Lumineszenzdiodenchip nach Anspruch 1,
**dadurch gekennzeichnet, dass**
mehrere Strombarrieren enthalten sind.

3. Lumineszenzdiodenchip nach einem der vorhergehenden Ansprüche,
**dadurch gekennzeichnet, dass**
mindestens eine Strombarriere enthalten ist, die undotiertes oder derart schwach dotiertes Halbleitermaterial aufweist, das dessen elektrische Leitfähigkeit weniger als ein Zehntel der elektrischen Leitfähigkeit von einem an die Strombarriere angrenzenden Halbleitermaterial der Halbleiterschichtenfolge beträgt.

4. Lumineszenzdiodenchip nach einem der vorhergehenden Ansprüche,
**dadurch gekennzeichnet, dass**
mindestens eine Strombarriere enthalten ist, die derart leitend dotiertes Halbleitermaterial aufweist, dass dieses Halbleitermaterial gemeinsam mit einem angrenzenden Halbleitermaterial bei Betrieb des Lumineszenzdiodenchips einen in Sperrrichtung betriebenen pn-Übergang bildet.

5. Lumineszenzdiodenchip nach einem der vorhergehenden Ansprüche,
**dadurch gekennzeichnet, dass**
mindestens eine Strombarriere enthalten ist, die ein oxidiertes und/oder durch eingebrachte Ionen oder Atome derart modifiziertes Halbleitermaterial der epitaktischen Halbleiterschichtenfolge aufweist, dass dessen elektrische Leitfähigkeit weniger als ein Zehntel der elektrischen Leitfähigkeit von einem an die Strombarriere angrenzenden Halbleitermaterial beträgt.

6. Lumineszenzdiodenchip nach einem der vorhergehenden Ansprüche,
**dadurch gekennzeichnet, dass**
in der Halbleiterschichtenfolge mindestens eine Strombarriere mit Halbleitermaterial und zwischen der Strombarriere und der Stromaufweitungsschicht eine strahlungserzeugende Zone enthalten ist.

7. Lumineszenzdiodenchip nach einem der vorhergehenden Ansprüche,
**dadurch gekennzeichnet, dass**
mindestens eine Strombarriere enthalten ist, die ein an die Stromaufweitungsschicht und/oder den elektrischen Anschlusskörper angrenzendes Halbleitermaterial aufweist.

8. Lumineszenzdiodenchip nach einem der vorhergehenden Ansprüche,
**dadurch gekennzeichnet, dass**
die Ionen oder Atome durch Lithium oder Kupfer gebildet sind.

9. Lumineszenzdiodenchip nach einem der vorhergehenden Ansprüche,
**dadurch gekennzeichnet, dass**
die Stromaufweitungsschicht an eine Halbleiterschicht der epitaktischen Halbleiterschichtenfolge angrenzt und dass die Grenzfläche einen ersten Teil, in dem ein elektrisch leitfähiger Kontakt zwischen der Stromaufweitungsschicht und der Halbleiterschicht ausgebildet ist, und einen zweiten Teil aufweist, in dem kein elektrisch leitfähiger Kontakt oder in dem ein elektrisch leitfähiger Kontakt mit einer Leitfähigkeit von weniger als einem Zehntel der elektrischen Leitfähigkeit des Kontaktes in dem ersten Teil zwischen der Stromaufweitungsschicht und der Halbleiterschicht ausgebildet ist.

10. Lumineszenzdiodenchip nach einem der vorhergehenden Ansprüche,
**dadurch gekennzeichnet, dass**
die Stromaufweitungsschicht teilweise oder vollständig lateral mit mindestens einer Strombarriere überlappt.

11. Lumineszenzdiodenchip nach einem der vorherigen Ansprüche,
**dadurch gekennzeichnet, dass**
ein Teil der Stromaufweitungsschicht auf einer von der Halbleiterschichtenfolge abgewandten Seite des Anschlusskörpers angeordnet ist.

12. Lumineszenzdiodenchip nach einem der vorhergehenden Ansprüche,
**dadurch gekennzeichnet, dass**
mindestens eine Strombarriere enthalten ist, die lateral vollständig mit dem Anschlusskörper überlappt und den Anschlusskörper lateral überragt.

13. Lumineszenzdiodenchip nach einem der vorhergehenden Ansprüche,
**dadurch gekennzeichnet, dass**
zusätzlich eine Strombarriere enthalten ist, die durch eine Grenzfläche zwischen der Halbleiterschichtenfolge und dem elektrischen Anschlusskörper gebildet ist.

14. Lumineszenzdiodenchip nach einem der vorhergehenden Ansprüche,
**dadurch gekennzeichnet, dass**
eine zwischen zwei Mantelschichten angeordnete strahlungserzeugende Zone enthalten ist, wobei die epitaktische Halbleiterschichtenfolge zwischen einer der Mantelschichten und der Stromaufweitungsschicht aus einem äußeren Teil besteht, der eine Dicke von kleiner als oder gleich 100 nm aufweist.

15. Lumineszenzdiodenchip nach Anspruch 14,
**dadurch gekennzeichnet, dass**
der äußere Teil der Halbleiterschichtenfolge eine Dicke von kleiner als oder gleich 60 nm aufweist.

## Claims

1. A luminescence diode chip, which has an epitaxial semiconductor layer sequence (1) suitable for generating electromagnetic radiation, an electrical connecting element (2), a radiation-transmissive current-spreading layer (3) connected in an electrically conductive manner to the connecting element and with a TCO (transparent conductive oxide), and at least one current barrier (4), which is suitable for selectively preventing or reducing the generation of radiation in a region covered laterally by the connecting element (2) by a reduced current density,
**characterized in that**
the current barrier or at least one of the current barriers is formed of material of the current-spreading layer, so that the current barrier (4) comprises a portion of the TCO of the current-spreading layer (3), wherein this portion of the TCO is modified by introduced ions or atoms in such a way that its electrical conductivity is less than a tenth of the electrical conductivity of a remaining TCO of the current spreading-layer (3).

2. The luminescence diode chip according to Claim 1, **characterized in that** several current barriers are present.

3. The luminescence diode chip according to any one of the previous Claims,
**characterized in that**
at least one current barrier is present, which has undoped semiconductor material or weakly doped semiconductor material so that its electrical conductivity is less than a tenth of the electrical conductivity of a semiconductor material of the semiconductor layer sequence bordering the current barrier.

4. The luminescence diode chip according to any one of the previous Claims,
**characterized in that**
at least one current barrier is present, which has conductively doped semiconductor material in such a way that this semiconductor material together with an adjacent semiconductor material forms a pn-junction operated in the blocking direction during operation of the luminescence diode chip.

5. The luminescence diode chip according to any one of the previous Claims,
**characterized in that**
at least one current barrier is present, which has a semiconductor material of the epitaxial semiconductor layer sequence, which semiconductor material is oxidized and/or modified by introduced ions or atoms in such a way that its electrical conductivity is less than a tenth of the electrical conductivity of a semiconductor material bordering the current barrier.

6. The luminescence diode chip according to any one of the previous Claims,
**characterized in that**
in the semiconductor layer sequence at least one current barrier with semiconductor material and between the current barrier and the current-spreading layer a radiation-generating zone are present.

7. The luminescence diode chip according to any one of the previous Claims,
**characterized in that**
at least one current barrier is present, which has a semiconductor material bordering on the current-spreading layer and/or the electrical connecting element.

8. The luminescence diode chip according to any one of the previous Claims,
**characterized in that**
the ions or atoms are formed by lithium or copper.

9. The luminescence diode chip according to any one of the previous Claims,
**characterized in that**
the current-spreading layer borders a semiconductor layer of the epitaxial semiconductor layer sequence and the boundary surface has a first part, in which an electrically conductive contact is constructed between the current-spreading layer and the semiconductor layer, and has a second part, in which no electrically conductive contact or in which an electrically conductive contact with a conductivity of less than a tenth of the electrical conductivity of the contact in the first part is constructed between the current-spreading layer and the semiconductor layer.

10. The luminescence diode chip according to any one of the previous Claims,
**characterized in that**
the current-spreading layer partially or completely overlaps laterally with at least one current barrier.

11. The luminescence diode chip according to any one of the previous Claims,
**characterized in that**
a part of the current-spreading layer is arranged on a side of the connecting element remote from the semiconductor layer sequence.

12. The luminescence diode chip according to any one of the previous Claims,
**characterized in that**
at least one current barrier is present, which completely overlaps with the connecting element laterally and overtops the connecting element laterally.

13. The luminescence diode chip according to any one of the previous Claims,
**characterized in that**
a current barrier is additionally present that is formed by a boundary surface between the semiconductor layer sequence and the electrical connecting element.

14. The luminescence diode chip according to any one of the previous Claims,
**characterized in that**
a radiation-generating zone arranged between two shell layers is present, wherein the epitaxial semiconductor layer sequence between one of the shell layers and the current-spreading layer consists of an outer part, which has a thickness of less than or equal to 100 nm.

15. The luminescence diode chip according to Claim 14,
**characterized in that**
the outer part of the semiconductor layer sequence has a thickness of less than or equal to 60 nm.

## Revendications

1. Puce à diode électroluminescente, qui présente une succession de couches semi-conductrices (1) épitaxiale appropriée afin de générer un rayonnement électromagnétique, un corps de raccordement électrique (2), une couche d'évasement de l'électricité (3) perméable au rayonnement et raccordée de façon conductrice d'électricité avec le corps de raccordement avec un TCO (transparent conductive oxide ou oxyde transparent conducteur), et au moins une barrière électrique (4) appropriée afin d'empêcher ou de réduire sélectivement la génération du rayonnement dans une zone couverte latéralement par le corps de raccordement (2) par le biais d'une densité de courant réduite, **caractérisée en ce que** la barrière électrique ou au moins une des barrières électriques est constituée en le matériau de la couche d'évasement de l'électricité, de sorte que la barrière électrique (4) englobe une partie du TCO de la couche d'évasement de l'électricité (3), cette partie du TCO étant modifiée de telle manière par des ions ou atomes apportés que sa conductivité électrique s'élève à moins d'un dixième de la conductivité électrique d'un autre TCO de la couche d'évasement de l'électricité (3).

2. Puce à diode électroluminescente selon la revendication 1, **caractérisée en ce que** plusieurs barrières électriques sont contenues.

3. Puce à diode électroluminescente selon l'une des revendications précédentes, **caractérisée en ce qu'**au moins une barrière électrique est contenue, laquelle présente un matériau semi-conducteur est non dopé ou faiblement dopé de telle sorte que sa conductivité électrique s'élève à moins d'un dixième de la conductivité électrique d'un matériau semi-conducteur de la succession de couches semi-conductrices contigu à la barrière électrique.

4. Puce à diode électroluminescente selon l'une des revendications précédentes, **caractérisée en ce qu'**au moins une barrière électrique est contenue, laquelle présente un matériau semi-conducteur dopé de telle sorte de façon conductrice que ce matériau semi-conducteur et un matériau semi-conducteur contigu constituent conjointement une transition pn exploitée en sens inverse lors du fonctionnement de la puce à diode électroluminescente.

5. Puce à diode électroluminescente selon l'une des revendications précédentes, **caractérisée en ce qu'**au moins une barrière électrique est contenue, laquelle présente un matériau semi-conducteur de la succession de couches semi-conductrices épitaxiale oxydé et/ou modifié de telle manière via l'apport d'ions ou d'atomes que sa conductivité électrique s'élève à moins d'un dixième de la conductivité électrique d'un matériau semi-conducteur contigu à la barrière électrique.

6. Puce à diode électroluminescente selon l'une des revendications précédentes, **caractérisée en ce que** la succession de couches semi-conductrices contient au moins une barrière électrique avec matériau semi-conducteur et une zone génératrice de rayonnement entre la barrière électrique et la couche d'évasement de l'électricité.

7. Puce à diode électroluminescente selon l'une des revendications précédentes, **caractérisée en ce qu'**au moins une barrière électrique est contenue, laquelle présente un matériau semi-conducteur contigu à la couche d'évasement de l'électricité et/ou au corps de raccordement électrique.

8. Puce à diode électroluminescente selon l'une des revendications précédentes, **caractérisée en ce que** les ions ou atomes sont constitués par du lithium ou du cuivre.

9. Puce à diode électroluminescente selon l'une des revendications précédentes, **caractérisée en ce que** la couche d'évasement de l'électricité est contiguë à une couche semi-conductrice de la succession de couches semi-conductrices épitaxiale et **en ce que** la surface de séparation présente une première partie dans laquelle un contact conducteur d'électricité est constitué entre la couche d'évasement de l'électricité et la couche semi-conductrice, et une deuxième partie dans laquelle aucun contact conducteur d'électricité ou dans laquelle un contact conducteur d'électricité avec une conductivité inférieure à un dixième de la conductivité électrique du contact dans la première partie est constitué entre la couche d'évasement de l'électricité et la couche semi-conductrice.

10. Puce à diode électroluminescente selon l'une des revendications précédentes, **caractérisée en ce que** la couche d'évasement de l'électricité se chevauche partiellement ou intégralement latéralement avec au moins une barrière électrique.

11. Puce à diode électroluminescente selon l'une des revendications précédentes, **caractérisée en ce qu'**une partie de la couche d'évasement de l'électricité est disposée sur un côté du corps de raccordement éloigné de la succession de couches semi-conductrices.

12. Puce à diode électroluminescente selon l'une des revendications précédentes, **caractérisée en ce qu'**au moins une barrière électrique est contenue, qui se chevauche latéralement intégralement avec le corps de raccordement et dépasse latéralement le corps de raccordement.

13. Puce à diode électroluminescente selon l'une des revendications précédentes, **caractérisée en ce qu'**une barrière supplémentaire est contenue, laquelle est constituée par une surface de séparation entre la succession de couches semi-conductrices et le corps de raccordement électrique.

14. Puce à diode électroluminescente selon l'une des revendications précédentes, **caractérisée en ce qu'**une zone génératrice de rayonnement disposée entre deux couches de revêtement est contenue, dans laquelle la succession de couches semi-conductrices épitaxiale consiste, entre l'une des couches de revêtement et la couche d'évasement de l'électricité, en une partie extérieure présentant une épaisseur inférieure ou égale à 100 nm.

15. Puce à diode électroluminescente selon la revendication 14, **caractérisée en ce que** la partie extérieure de la succession de couches semi-conductrices présente une épaisseur inférieure ou égale à 60 nm.
